# EUROPEAN PATENT APPLICATION

(11) **EP 2 952 913 A1**
(43) Date of publication of application: **09.12.2015**
(21) Application number: 15169128.4
(22) Date of filing: 26.05.2015
(51) Int. Cl.: G01R 15/24, G01R 19/32

(54) **OPTICAL VOLTAGE MEASURING APPARATUS**

(30) Priority: 03.06.2014 JP 2014114621
(71) Applicant: Kabushiki Kaisha Toshiba, Tokyo 105-8001 (JP)
(72) Inventor: Takahashi, Masao, Tokyo 105-8001 (JP)
(74) Representative: Ekstedt, Måns

(57) **Abstract**

An optical voltage measuring apparatus includes at least a light source, an optical branching device, a polarizer, a phase modulator, a transmission fiber, a Faraday rotator that turns the polarized wave of emitted light from the fiber, an electro-optic element that applies refraction index change by a Pockels effect to the turned light, a reflector mirror, and a detector. When the temperature coefficient of the sensitivity of the electro-optic element is positive, incident polarized light orientation of the Faraday rotator to the electro-optic element is set so as to be coaxial with the axis of birefringence that appears by the Pockels effect at the lowest temperature in a service temperature range. When the temperature coefficient of the sensitivity of the electro-optic element is negative, the same setting is made at the highest temperature in the service temperature range.

## Description

### FIELD

Embodiments of the present disclosure relate to an optical voltage measuring apparatus that measures the voltage of a power transmission/distribution cable, the shared voltage of a power device, etc.

### BACKGROUND

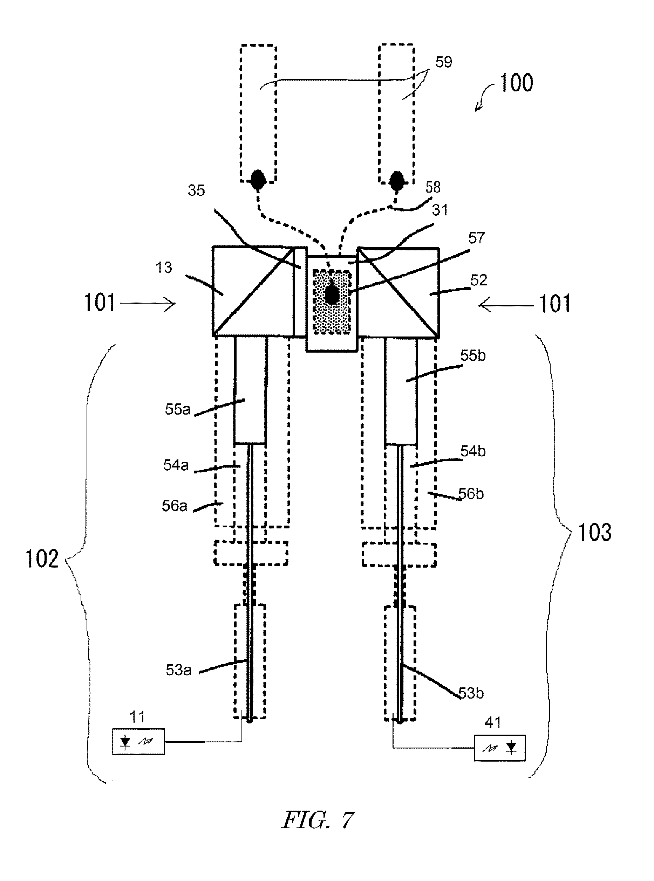

FIG. 7 illustrates an example structure of a conventional optical voltage measuring apparatus.

This optical voltage measuring apparatus 100 includes a sensor unit 101, a light emitting unit 102, a light receiving unit 103, and unillustrated signal processing circuits at the light emitting side and the light receiving side.

The sensor unit 101 includes a polarizer 13, 1/4 wavelength plate 35 (hereinafter, sometimes referred to as "λ/4 plate"), an electro-optic element 31, and an analyzer 52 all disposed in this order from the light incidence side and on the same optical axis.

In addition, the light emitting unit 102 includes an E/O circuit including a light source 11 that is LEDs (light Emitting Diodes), etc., and, an input optical system that includes an optical fiber 53a, a ferrule 54a, a GRIN lens 55a, and a holder 56a all disposed on the same optical axis. Respective optical components in this input optical system are adhered with each other at respective optical planes contacting with each other by a bond.

Still further, the light receiving unit 103 includes an output optical system that includes an optical fiber 53b, a ferrule 54b, a GRIN lens 55b and a holder 56b all disposed on the same optical axis, and, an O/E circuit that includes a detector 41 which converts optical signals output by the output optical system into electric signals, and which detects the converted signals. Respective optical components in this output optical system are also adhered with each other at respective optical planes contacting with each other by a bond.

In the sensor unit 101 of the optical voltage measuring apparatus 100, the respective optical components disposed on the same optical axis, i.e., the polarizer 13, the λ/4 plate 35, the electro-optic element 31, and the analyzer 52 have respective contacting optical planes adhered by a bond. In this case, the term optical plane means a vertical surface to the optical axis, and each optical component has two optical planes that are a light entering surface and a light outgoing surface (the same is applied in the following explanation). In addition, the electro-optic element 31 has a pair of electrodes 57 formed by vapor deposition, and each of the pair of electrodes 57 is electrically connected with each of a pair of electrode terminals 59 via a lead wire 58. The voltage to be measured by the optical voltage measuring apparatus 100 is applied across the terminals of the pair of electrode terminals 59.

The unillustrated signal processing circuits at the light emitting side and the light receiving side are connected with the sensor unit 101 through the light emitting unit 102 and the light receiving unit 103, respectively. The input-side optical plane of the polarizer 13 in the sensor unit 101 is fixed on the optical plane of the GRIN lens 55a in the light emitting unit 102 by a bond. The output-side optical plane of the analyzer 52 in the sensor unit 101 is fixed on the optical plane of the GRIN lens 55b in the light receiving unit 103 by a bond. The input-side optical system in the sensor unit 101 and the light emitting unit 102 which are bonded to be fixed each other, and the output-side optical system in the light receiving unit 103 are mechanically fixed to an unillustrated casing. For example, an epoxy-based or urethane-based resin are utilized as a bond applied for each optical component in the optical voltage measuring apparatus 100. Still further, an example electro-optic element 31 is Bi₁₂SiO₂₀ (BSO, Bismuth Silicon Oxide), or KDP (KH₂PO₄).

Next, an explanation will be given of an operating principle of the optical voltage measuring apparatus 100 employing the above-explained structure. When, for example, LEDs with a center wavelength of 0.85 µm are applied as the light source 11 in the light emitting unit 102, non-polarized LED light is emitted from the light source 11, and after passing through the polarizer 13 in the sensor unit 101, this light becomes linear polarized light. When passing through the 1/4 wavelength plate 35, this linear polarized light becomes circular polarized light, and after passing through the electro-optic element 31, this circular polarized light becomes an ellipse in accordance with an applied voltage Vm to the electro-optic element 31. That is, the polarization condition of light that passes through the electro-optic element 31 changes in accordance with the applied voltage Vm. Such elliptical polarized light is received by the detector 41 after passing through the analyzer 52. A change in the output intensity corresponds to the polarization condition of the light that has passed through the electro-optic element 31. Since the polarization condition changes in accordance with the applied voltage Vm, the output intensity change in the analyzer 52 is monitored by an otipcal receiver through the optical fiber 53b at the light receiving side, and the modulation degree of the amount of light (intensity) is calculated. Hence, the applied voltage Vm can be measured. In this case, the term modulation degree of the amount of light means a ratio between the AC component of the amount of light and the DC component thereof.

However, since the optical voltage measuring apparatus 100 employs a scheme of measuring the applied voltage Vm by calculating the modulation degree of the amount of light, a DC voltage cannot be essentially measured. In addition, a sensitivity error, and a phase error are caused by an environmental changes like a temperature change, but since the behavior of such errors are different from that of a current measuring apparatus, an error is caused at the time of measuring impedance and voltage. This deteriorates the measurement precision. In addition, a voltage divider is necessary to perform measurement, and this voltage divider becomes a constraint for the measurement precision and the response speed.

Still further, according to optical voltage gauges designed for accomplishing the unnecessity of a voltage divider, light propagation in a gas at a long distance is required, and a large number of light sources and optical systems are necessary. Hence, there is a technical disadvantage from the standpoint of the precision and the reliability.

Conversely, a scheme of measuring a voltage based on a signal that is the amount of light itself has been studied, but in practice, the sensitivity change in a detector and the transmissivity change in an optical element directly result in an error, and thus it is difficult to obtain the necessary precision.

Embodiments of the present disclosure have been proposed in order to address the above-explained technical disadvantages of the conventional technologies, and it is an objective to provide an optical voltage measuring apparatus which can perform optical voltage measurement highly precisely, and which can accomplish a high reliability.

### SUMMARY

To accomplish the above objective, an optical voltage measuring apparatus according to an embodiment of the present disclosure includes at least: a light source; a first optical element converting light from the light source into linear polarized light; a phase modulator applying phase modulation to light converted into the linear polarized light; a fiber disposed so as to propagate the light converted into the linear polarized light in both of a delayed-phase axis and an advanced-phase axis; a second optical element turning polarized wave of emitted light from the fiber; an electro-optic element applying a refraction index change by a Pockels effect to the turned light; a reflector mirror reflecting light that has passed through the electro-optic element; an optical branching device branching the light which has been reflected by the reflector mirror and which has passed through the electro-optic element; and a detector detecting the branched light by the optical branching device, in which: when a temperature coefficient of a sensitivity of the electro-optic element is positive, incident polarized light orientation of the second optical element to the electro-optic element is set so as to be coaxial with an axis of birefringence that appears by the Pockels effect at a lowest temperature in a service temperature range; and when the temperature coefficient of the sensitivity of the electro-optic element is negative, the incident polarized light orientation of the second optical element to the electro-optic element is set so as to be coaxial with the axis of birefringence that appears by the Pockels effect at a highest temperature in the service temperature range.

In addition, an optical voltage measuring apparatus according to another embodiment of the present disclosure includes at least: a light source; a first optical element converting light from the light source into linear polarized light; a phase modulator applying phase modulation to light converted into the linear polarized light; a fiber disposed so as to propagate the light converted into the linear polarized light in both of a delayed-phase axis and an advanced-phase axis; a second optical element turning polarized wave of emitted light from the fiber; an electro-optic element applying a refraction index change by a Pockels effect to the turned light; a reflector mirror reflecting light that has passed through the electro-optic element; an optical branching device branching the light which has been reflected by the reflector mirror and which has passed through the electro-optic element; and a detector detecting the branched light by the optical branching device, in which the electro-optic element includes an electro-optic element with an optical rotation characteristic that turns a polarized wave of incident light.

### BRIEF DESCRIPTION OF THE DRAWINGS

FIG. 1 is a schematic diagram illustrating a general structure of an optical voltage measuring apparatus according to a first embodiment of the present disclosure;
FIG. 2 is a graph illustrating temperature characteristic of the sensitivity of BiGeO₂₀;
FIG. 3 is a schematic diagram illustrating action and effect of the optical voltage measuring apparatus of the first embodiment;
FIG. 4 is a schematic diagram illustrating a general structure of a composite optical voltage measuring apparatus according to a second embodiment of the present disclosure;
FIG. 5 is a schematic diagram illustrating a structure of an inline-Sagnac-type optical current sensor;
FIG. 6 is a schematic diagram illustrating a general structure of a multi-stage optical voltage measuring apparatus according to a third embodiment of the present disclosure; and
FIG. 7 is a transparent front view of an example structure of a conventional optical voltage measuring apparatus.

### DETAILED DESCRIPTION OF THE EMBODIMENTS

Embodiments of the present disclosure will be explained below in detail with reference to the accompanying figures.

### [First Embodiment]

### (General Structure of Optical Voltage Measuring Apparatus 10)

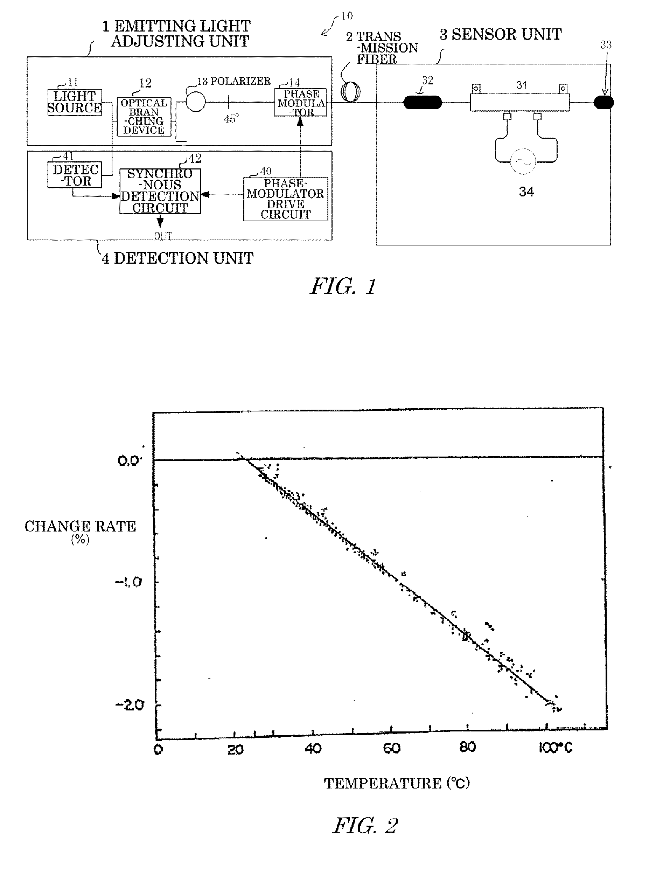

FIG. 1 illustrates a general structure of an optical voltage measuring apparatus according to a first embodiment of the present disclosure.

An optical voltage measuring apparatus 10 includes an emitting light adjusting unit 1 which adjusts the polarization plane for emitted light from a light source, and which adjusts the phase of such light, a sensor unit 3 that causes, through an electro-optic element 31, a phase difference proportional to an applied voltage, a transmission fiber 2 that connects the emitting light adjusting unit 1 with the sensor unit 3, and a detecting unit 4 which performs detection and which calculates a voltage.

### (Emitting Light Adjusting Unit 1)

The emitting light adjusting unit 1 includes a light source 11, an optical branching device (hereinafter, referred to as a "coupler" in some cases) 12, a polarizer 13, and a phase modulator 14.

The light source 11 emits light for current measurement, and includes, for example, Super Luminescence Diodes (SLDs). The light source 11 is connected with the optical branching device 12.

The optical branching device 12 divides incident light into two light components, and guides the divided light component to the polarizer 13 connected to one of the branches. In addition, the optical branching device 12 divides light returned from the sensor unit 3 to be discussed later into two light components, and guides the divided light component to the detecting unit 4.

The polarizer 13 converts the incoming light into light polarized in a specific direction, thereby setting light at the outgoing side to be linear polarized light. Example polarizers 13 available are a fiber-type polarizer that utilizes the polarization plane maintaining fiber, and a bulk-element type fiber polarizer that is a combination of a crystalline element and a polarization plane maintaining fiber. The polarization plane maintaining fiber of the polarizer 13 at the outgoing side is melted and connected with the optical axis inclined by 45 degrees. The polarization plane maintaining fiber of the polarizer 13 at the outgoing side maintains the polarization condition of two polarized components orthogonal to each other, and an example fiber is a stress-applying type polarization plane maintaining fiber. An example of such fiber is a PANDA fiber or a Bow-Tie fiber.

The phase modulator 14 applies, to light components that propagate in the phase modulator 14, a phase modulation by a predetermined phase difference. An example phase modulator 14 is a PZT type phase modulator including a piezo tube (PZT) and a polarization plane maintaining fiber wound therearound, or a Pockels-element type phase modulator utilizing a Pockels element. The phase modulator 14 is controlled by a phase-modulator drive circuit 40 to be discussed later. In addition, the polarization plane maintaining fiber of the phase modulator 14 at the outgoing side is connected with the transmission fiber 2. The transmission fiber 2 maintains the polarization condition of two polarized components orthogonal to each other.

### (Sensor Unit 3)

The sensor unit 3 includes a Faraday rotator 32, the electro-optic element 31, a reflector mirror 33, and an applied voltage 34.

The Faraday rotator 32 turns the polarization plane of light emitted from the transmission fiber 2 by, for example, 45 degrees to cause the light to enter the electro-optic element 31, or turns the polarization plane of light which is reflected by the reflector mirror 33 to be discussed later and which has passed through the electro-optic element 31 again by, for example, 45 degrees.

As the electro-optic element 31, an electro-optic crystal with a Pockels effect that changes the birefringent characteristics of light in accordance with an electric field is applied. An example of such a crystal is BiGeO₂₀ (bismuth germanium oxide), Bi₁₂SiO₂₀ (BSO, Bismuth Silicon Oxide), KDP (KH₂PO₄), ADP (NH₄H₂PO₄), LiNbO₃ (niobic acid lithium), or LiTaO₃ (tantalic acid lithium).

### (Temperature Dependency of Sensitivity of Electro-Optic Crystal)

It is known that the sensitivity of the above-explained electro-optic crystal changes in accordance with a temperature. For example, as illustrated in FIG. 2, the sensitivity of the BiGeO₂₀ crystal decreases by 2.0 % at 100 °C that is a high-temperature side. Conversely, there are electro-optic crystals that increase the sensitivity when the temperature rises. Hence, it is difficult to satisfy the necessary precision for general voltage measuring apparatuses, e.g., within 1 %, and any correction is necessary.

In this embodiment, by utilizing the optical rotation angle of the Faraday rotator 32 which changes in accordance with the temperature, a temperature correction is performed.

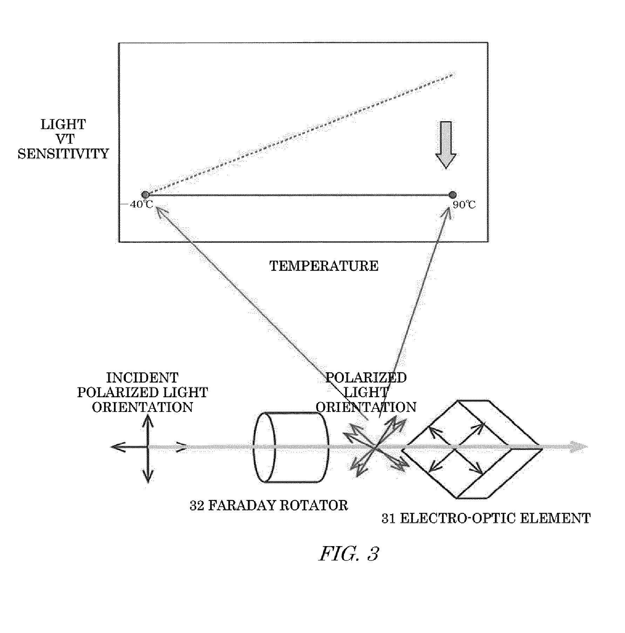

That is, as is indicted by a dotted line in FIG. 3, when the sensitivity of the electro-optic crystal increases at the high-temperature side (when the temperature coefficient of the sensitivity is positive), the optical rotation angle of the Faraday rotator 32 is set to be 45 degrees at the low-temperature side (e.g., -40 °C). At this time, when an incident polarized light orientation to the electro-optic element 31 is set so as to be coaxial with a birefringent axis that appears by a Pockels effect, the birefringence of lights in two orthogonal axes becomes the maximum.

Conversely, at the high-temperature side, the emitted polarized light orientation of the Faraday rotator 32 has a misalignment between the axis of birefringence of the electro-optic element 31 and the incident polarized light orientation to the electro-optic element 31 unlike the case of a low temperature. The phase difference applied to both polarized lights by birefringence becomes small by what corresponds to this misalignment, and the apparent sensitivity decreases. As a result, the sensitivity at a high temperature is suppressed, and the temperature characteristics of the sensitivity can be made flat as is indicated by a thick line in FIG. 3.

Conversely to the dotted line in FIG. 3, when the sensitivity of the electro-optic crystal increases at the high-temperature side (when the temperature coefficient of the sensitivity is negative), the optical rotation angle of the Faraday rotator 32 is set to be 45 degrees at the high-temperature side (e.g., 90 °C). At this time, when an incident polarized light orientation to the electro-optic element 31 is set so as to be coaxial with the birefringent axis that appears by a Pockels effect, the birefringence of lights in the two orthogonal axes becomes the maximum. Conversely, at the low-temperature side, the emitted polarized light orientation of the Faraday rotator 32 has a misalignment between the axis of birefringence of the electro-optic element 31 and the incident polarized light orientation to the electro-optic element 31 unlike the case of a high temperature. The phase difference applied to both polarized lights by birefringence becomes small by what corresponds to this misalignment, and the apparent sensitivity decreases. As a result, the sensitivity at a low temperature is suppressed, and the temperature characteristics of the sensitivity can be made flat as is indicated by the thick line in FIG. 3.

Instead of the flattening the temperature characteristics of the sensitivity of the optical voltage measuring apparatus 10 by utilizing the temperature dependency of the optical rotation of the Faraday rotator 32, the same effect can be accomplished by utilizing an electro-optic crystal with optical rotation characteristics. Table 1 shows the characteristics of typical electro-optic crystals with optical rotation characteristics. For example, there are electro-optic crystals that have no optical rotation characteristic like ZnS and Bi₄Ge₃O₁₂, but many crystals have the optical rotation characteristics. When such a crystal with the optical rotation characteristics is applied, optical rotation by the Faraday rotator and birefringence of the electro-optical crystal due to an electric field can be applied through a single electro-optic element as illustrated in FIG. 3.

**[Table 1]**

| | **Half-wavelength Voltage** | | **Optical Rotation Characteristics** |
|---|---|---|---|
| **Material** | **Voltage** | **Measured Wavelength** | |
| | (KV) | (µm) | (deg/mm) |
| ADP | 9.6 | 0.5461 | **Present** |
| KDP | 7.5 | 0.5461 | |
| Bi12TiO20 | 3.9 | 0.633 | 6.3 |
| Bi12SiO20 | 3.9 | 0.633 | 10.5 |
| | 6.8 | 0.870 | |
| Bi12GeO20 | 5.7 | 0.633 | 9.6 |

### (Detecting Unit 4)

The detecting unit 4 includes the phase-modulator drive circuit 40, a detector 41, and a synchronous detection circuit 42.

The phase-modulator drive circuit 40 generates a phase-modulation signal to control the phase modulator 14 of the emitting light adjusting unit 1.

The detector 41 detects the amount of light reflected by the sensor unit 3 and branched by the coupler 12. An example detector 41 applicable is an optical/electrical conversion element (O/E conversion element), such as a photo diode or a photomultiplier tube.

The synchronous detection circuit 42 performs synchronous detection on the amount of light detected by the detector 41 at a phase-modulation angular frequency. An example synchronous detection circuit 42 is a lock-in amplifier.

### (Action)

An action of the optical voltage measuring apparatus 10 will be explained below together with the actual flow of light.

First, the drive of the light source 11 is controlled by an unillustrated light-source drive circuit in the emitted light adjusting unit 1 to emit light. The emitted light from the light source 11 enters the coupler 12 that is an optical branching device. The emitted light is divided into two light components by the coupler 12, and one divided light component enters the polarizer 13. Note that the other divided light component is delivered the exterior of the optical voltage measuring apparatus 10.

Light before entering the polarizer 13 contains polarized light components in plural directions, but after the light passes through the polarizer 13, it becomes polarized light in a specific direction, i.e., linear polarized light. This linear polarized light enters the phase modulator 14 that is melted and connected with the optical axis being inclined by 45 degrees relative to the polarizer 13.

The phase modulator 14 employs a structure in which the polarization plane maintaining fiber is wound around the piezo oscillator, and the fiber is elongated or contracted by this piezo oscillator, thereby performing phase modulation. Since the optical axis between the emitted light from the polarizer 13 and the polarization plane maintaining fiber of the modulator is inclined by 45 degrees, the linear polarized light enters the polarization plane maintaining fiber in a condition inclined by 45 degrees relative to the two orthogonal axes which are an x-axis and a y-axis. The linear polarized light that has entered the polarization plane maintaining fiber then contains a light component that is linear polarized light in the x-axis direction, and the remaining light component that is linear polarized light in the y-axis direction. In this case, the linear polarized light with two axial components is propagated under the constraint by the respective optical axes of the polarization plane maintaining fiber.

In this case, in order to simplify the explanation, it is presumed that the phase modulator 14 controlled by the phase-modulator drive circuit 40 applies a phase modulation at a constant angular frequency and a constant amplitude to either one component of the polarized light components in the x-axis direction and the y-axis direction. For example, it is presumed that the phase modulator 14 applies a phase modulation to only the polarized light component in the x-axis direction.

In the phase modulator 14, when a phase modulation by a phase difference θ is applied to the linear polarized light component in the x-axis direction which propagates the phase modulator 14, the linear polarized light component in the x-axis direction receives the phase modulation at a time t. Hence, the two linear polarized light components in the x-axis direction and the y-axis direction after passing through the phase modulator 14 have a phase difference. In addition, the phase modulator 14 outputs a utilized phase-modulation angular frequency to the synchronous detection circuit 42.

The two linear polarized light components in the x-axis direction and the y-axis direction which have passed through the phase modulator 14 enters the transmission fiber 2. The two linear polarized light components in the x-axis direction and the y-axis direction are propagated under the constraints by the respective two optical axes also in the transmission fiber 2.

Light emitted from the transmission fiber 2 has the polarization condition turned by 45 degrees by the Faraday rotator 32, and enters the electro-optic element 31. The axis of the electro-optic element 31 at this time is set to be 45 degrees relative to the transmission fiber 2, and light components propagated in the fiber along the x-axis and the y-axis receive a phase difference by the electro-optic element 31 which is proportional to the applied voltage 34.

Light emitted from the electro-optic element 31 is reflected by a reflector mirror 33, and receives a phase difference again from the electro-optic element 31. Hence, the applied phase difference becomes twice as much as that of the one-way of the optical path. Before this light enters the transmission fiber 2 again, the polarization plane is turned by 45 degrees by the Faraday rotator 32. Hence, light component that has propagated along the x-axis in the first half of the propagation now propagates along the y-axis direction and turns back, and light component that has propagated along the y-axis direction in the first half of the propagation now propagates along the x-axis direction and turns back. Therefore, no phase difference occurs in the transmission fiber 2. Accordingly, only the phase difference by the electro-optic element 31 appears.

The two linear polarized light components in the x-axis direction and the y-axis direction enter again the transmission fiber 2, propagate therein, and enter the phase modulator 14. In this case, for example, the phase modulator 14 applies a phase modulation to the linear polarized light component in the x-axis direction only. In the phase modulator 14, when a phase modulation by a phase difference θ' is applied to the linear polarized light component in the x-axis direction which propagates the phase modulator 14, the polarized light component in the x-axis direction receives the phase modulation at a time t'. Hence, the two linear polarized light components in the x-axis direction and the y-axis direction have a phase difference after passing through the phase modulator 14. In addition, the phase modulator 14 outputs the utilized phase-modulation angular frequency to the synchronous detection circuit 42.

The two linear polarized light components in the x-axis direction and the y-axis direction output by the phase modulator 14 enter the polarizer 13. At this time, the phase modulator 14 is connected so as to be inclined by 45 degrees relative to the polarizer 13. Hence, the two linear light components in the x-axis direction and the y-axis direction are multiplexed, and interfere with each other.

Light that has passed through the polarizer 13 enters the coupler 12 again and is divided, and the one divided light component enters and is detected by the detector 41. Next, the amount of light detected by the detector 41 is subjected to synchronous detection by the synchronous detection circuit 42 at the phase-modulation angular frequency input from the phase-modulator drive circuit 40.

### (Effects)

According to this embodiment, an optical voltage measurement is performed based on not a change in the amount of light but a change in phase. Hence, a highly-precise and highly-reliable optical voltage measurement can be performed without the needs for considering a change in the amount of light and the adverse effect by DC drift, etc., of the detector.

In addition, according to this embodiment, the temperature correction is performed by utilizing the optical rotation angle of the Faraday rotator 32 which changes in accordance with a temperature. Hence, even if the sensitivity of the crystal of the electro-optic element 31 changes due to a temperature, the temperature characteristics of the sensitivity of the optical voltage measuring apparatus 10 can be made flat.

### [Second Embodiment]

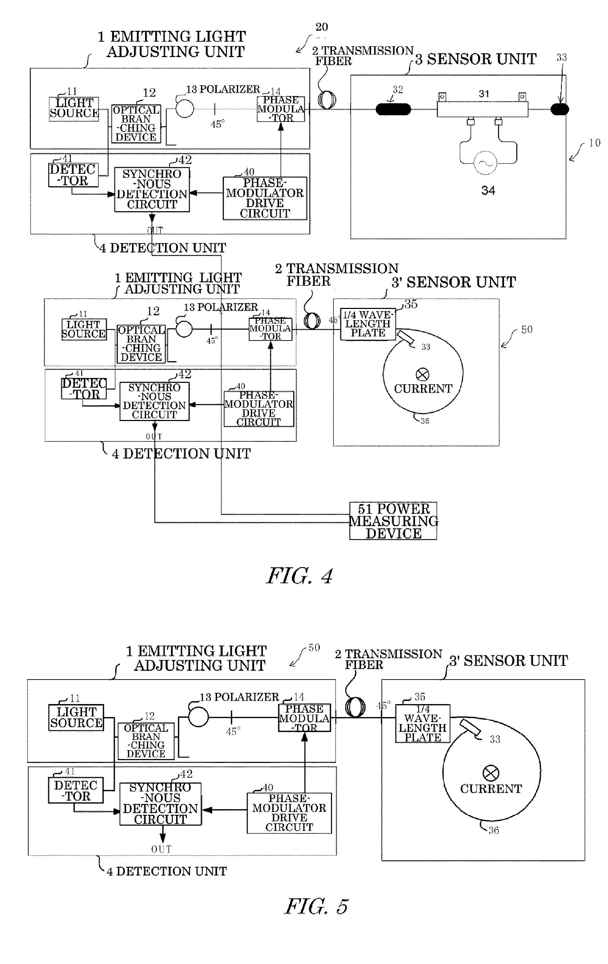

FIG. 4 illustrates a general structure of a composite optical voltage measuring apparatus according to a second embodiment of the present disclosure.

A composite optical voltage measuring apparatus 20 of this embodiment is a combination of the optical voltage measuring apparatus 10 of the first embodiment with an inline-Sagnac-interference type optical current sensor 50, and is connected with a power measuring device 51 that measures a voltage through the optical voltage measuring apparatus 10 and a current through the optical current sensor 51.

The optical voltage measuring apparatus 10 not only functions as the voltage measuring apparatus alone like the first embodiment but is also utilized to actuate a protective system called a distance relay by measuring power, the amount of power or reactive power in combination with a current gauge, and calculating impedance. At this time, it is quite important that the phase relationship with the current gauge is precisely matching.

Since the structure of the optical voltage measuring apparatus 10 were explained in detail in the first embodiment, the following explanation will be given of the details of the inline-Sagnac-interference type optical current sensor 50.

The inline-Sagnac-interference type optical current sensor 50 applies a phase difference by utilizing a Faraday effect unlike the optical voltage measuring apparatus 10 that applies a phase difference to light components propagating in the x-axis direction and the y-axis direction in the polarization plane maintaining fiber by a Pockels effect. Hence, the optical current sensor 50 basically employs the structure of the optical voltage measuring apparatus 10 in FIG. 1, but also employs several different structural components. The component with the same function as that of the optical voltage measuring apparatus 10 in FIG. 1 will be denoted by the reference numeral, and the duplicated explanation will be omitted. The explanation will be mainly given of the difference.

### (Structure of Inline-Sagnac-Type Optical Current Sensor 50)

FIG. 5 illustrates a structure of the inline-Sagnac-type optical current sensor 50 utilized for the composite optical voltage measuring apparatus 20 according to this embodiment.

The optical current sensor 50 includes an emitting light adjusting unit 1 which adjusts the polarization plane for emitted light from a light source, and which adjusts the phase of such light, a sensor unit 3' that produces a phase difference between right and left polarized lights traveling the optical fiber by a magnetic field of a current, a transmission fiber 2 that connects the emitting light adjusting unit 1 with the sensor unit 3', and a detecting unit 4 which performs detection and which calculates a current.

Since the emitting light adjusting unit 1, the transmission fiber 2, and the detecting unit 4 are the same as those of the optical voltage measuring apparatus 10 in FIG. 1, the duplicated explanation will be omitted.

### (Sensor Unit 3')

The sensor unit 3' includes a 1/4 wavelength plate 35, a sensor fiber 36, and a reflector mirror 33.

The 1/4 wavelength plate 35 connected with the transmission fiber 2 with the optical axis thereof inclined by 45 degrees causes a phase difference by 1/4 wavelength to incident light. The outgoing side of the 1/4 wavelength plate 35 is connected with the sensor fiber 36.

The sensor fiber 36 causes a Faraday phase difference. This sensor fiber 36 is disposed circularly so as to encircle a current to be measured. The reflector mirror 33 that reflects light from the sensor fiber 36 is provided at an end of the sensor fiber 36.

### (Action)

An explanation will be given of an action of this composite optical voltage measuring apparatus 20 together with the actual flow of light.

First of all, since the portion that is the optical voltage measuring apparatus 10 in the composite optical voltage measuring apparatus 20 is consistent with that of the first embodiment, the duplicated explanation will be omitted. The action of the portion for the inline-Sagnac-type optical current sensor 50 will be explained with reference to FIG. 5.

The action of the emitting light adjusting unit 1 and that of the transmission fiber 2 are consistent with those of the optical voltage measuring apparatus 10 in FIG. 1, and thus the duplicated explanation will be omitted.

Next, two linear polarized light components in the x-axis direction and the y-axis direction which has passed through the transmission fiber 2 enter the 1/4 wavelength plate 35 of the sensor unit 3'. The 1/4 wavelength plate 35 causes a phase difference by 1/4 wavelength in the two entering linear polarized light components, and converts those light components into two circular polarized light components in opposite directions that are the right circular polarized light component and the left circular polarized light component. Those right and left circular polarized light components enter the sensor fiber 36.

In the sensor fiber 36, the right and left polarized light components receive the Faraday effect by a magnetic field in the opposite direction although the traveling direction is the same. Hence, a Faraday phase difference is caused between the right and left circular polarized light components. In addition, the reflector mirror 33 provided at the end of the sensor fiber 36 reflects the right and left circular polarized light components, and returns those light components in the sensor fiber 36.

The right and left circular polarized light components turned back by the reflector mirror 33 receive a Faraday effect again by the sensor fiber 36, and thus the phase difference by the Faraday effect applied to the right and left circular polarized light components becomes twice. The right and left circular polarized light components that have passed through the sensor fiber 36 enter the 1/4 wavelength plate 35. The 1/4 wavelength plate 35 applies a phase difference by 1/4 wavelength to the right and left circular polarized light components, and those light components again become linear light with two axial components.

At this time, light propagated as the linear polarized light component in the x-axis direction before entering the sensor unit 3' is converted into the linear polarized light component in the y-axis direction. In addition, light propagated as the linear polarized light component in the y-axis direction before entering the sensor unit 3' becomes the linear polarized light component in the x-axis direction. That is, the linear polarized light with the x-axis component in the first half of the propagation then propagates as the linear polarized light with the y-axis component in the second half of the propagation, and the linear polarized light with the y-axis component in the first half of the propagation then propagates as the linear polarized light with the x-axis component in the second half of the propagation. Hence, the two linear polarized light components travel the same optical path in the first half and second half of the propagation, and thus there is no phase difference due to an optical path difference.

The two linear polarized light components in the x-axis direction and the y-axis direction again enter the transmission fiber 2, propagate therein, and enter the phase modulator 14. In this case, for example, the phase modulator 14 applies a phase modulation only to the linear polarized light component in the x-axis direction. When the phase modulator 14 applies the phase modulation by a phase difference θ' to the linear polarized light component in the x-axis direction propagating the phase modulator 14, the linear polarized light component in the x-axis direction receives, at a time t', the phase modulation. Hence, the two linear polarized light components in the x-axis direction and the y-axis direction after passing through the phase modulator 14 have a phase difference. In addition, the phase modulator 14 outputs the utilized phase-modulation angular frequency to the synchronous detection circuit 42.

The two linear polarized light components in the x-axis direction and the y-axis direction output by the phase modulator 14 enter the polarizer 13. At this time, since the phase modulator 14 is connected so as to be inclined by 45 degrees relative to the polarizer 13. Hence, the two linear light components in the x-axis direction and the y-axis direction are multiplexed, and interfere with each other.

Light that has passed through the polarizer 13 enters the coupler 12 again and is divided, and, the one divided light component enters and is detected by the detector 41. Next, the amount of light detected by the detector 41 is subjected to synchronous detection by the synchronous detection circuit 42 at the phase-modulation angular frequency input from the phase modulator drive circuit 40.

When the detected light signal is subjected to the synchronous detection based on a harmonic component of a phase-modulation angular frequency ωm, a synchronous detection output Pnω becomes as follow:
Pωm oc J1 (2δsinωnα) sin4θf Detection signal for fundamental wave
P2ωm oc J2 (2δsinωnα) cos4θf Detection signal for double harmonic
P3ωm oc J3 (2δsinωnα) sin4θf Detection signal for triple harmonic
P4ωm oc J4 (2δsinωnα) cos4θf Detection signal for quadruple harmonic
where Jn is the Bessel function of the n-th degree, and θf is a Faraday rotation angle.

As is clear from those equations, within a range where θf is small, a signal proportional to the sine of the measured current can be obtained based on an odd-number harmonic signal. Since the amount of light can be obtained based on an even-number order harmonic signal, the current can be precisely measured based on the ratio of those signals even if there is a fluctuation in the amount of light.

### (Effects)

In the composite optical voltage measuring apparatus 20 of this embodiment, the optical voltage measuring apparatus 10 and the optical current sensor 50 employ the same structure except the sensor units, and both sensor units are optical sensors that have a short optical path. Hence, a time delay does not become a practical problem. Accordingly, it becomes possible to realize a sensor pair with ideally similar phase characteristics, and thus a highly precise measurement excluding the problem originating from a phase difference can be realized.

### [Third Embodiment]

### (Structure)

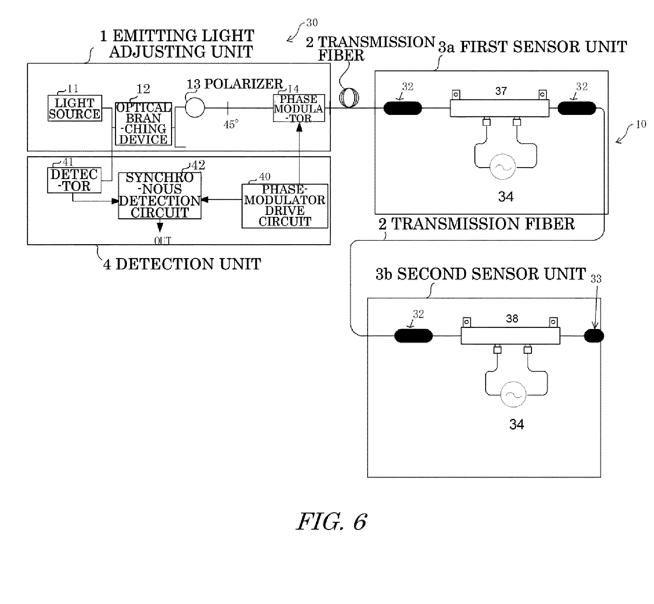

FIG. 6 illustrates a general structure of a multi-stage optical voltage measuring apparatus according to a third embodiment of the present disclosure.

A multi-stage optical voltage measuring apparatus 30 of this embodiment employs a structure in which the sensor unit 3 of the optical voltage measuring apparatus 10 of the first embodiment is replaced with two stage sense units that are a first sensor unit 3a and a second third sensor unit 3b. A first electro-optic element 37 in the first sensor unit 3a and a second electro-optic element 38 in the second sensor unit 3b are connected in series through the Faraday rotators 32.

### (Action)

The action of the emitting light adjusting unit 1 and that of the transmission fiber 2 are the same as those of the optical voltage measuring apparatus 10 in FIG. 1, and thus the duplicated explanation will be omitted.

Light emitted from the transmission fiber 2 is turned by 45 degrees by the Faraday rotator 32 in the first sensor unit 3a, and a phase difference proportional to a voltage is applied to this light by the first electro-optic element 37. This light is further turned by 45 degrees by the Faraday rotator 32, and is guided to the second electro-optic element 38 of the second sensor unit 3b through the transmission fiber 2.

That is, light that has propagated along the x-axis direction in the first half of the propagation passes through the first electro-optic element 37 in the x-axis direction, propagates the transmission fiber 2 in the x-axis direction, and is guided to the second sensor unit 3b. Light eventually reflected by the reflector mirror 33 in the second sensor unit 3b and is turned in the y-axis direction passes through the second electro-optic element 38, propagates the first electro-optic element 37 through the Faraday rotator 32, is further turned by 45 degrees by the Faraday rotator 32, and is turned back to the transmission fiber 2 in the y-axis direction.

Hence, only the phase difference of the first electro-optic element 37 and the second electro-optic element 38 is applied, and with the first sensor unit 3a and the second sensor unit 3b being connected with each other, a voltage V₁ at the first sensor unit 3a and a voltage V₂ at the sensor unit 3b, and, a total voltage (V₁ + V₂) can be measured.

### (Effects)

According to the multi-stage optical voltage measuring apparatus 30 of this embodiment, a measuring apparatus that can measure a total voltage of two points can be easily realized, and a voltage drop at a halfway point can be also measured.

### [Other Embodiments]

(1) According to the second embodiment, the explanation was given of the composite optical voltage measuring apparatus 20 that is a combination of the optical voltage measuring apparatus 10 with the inline-Sagnac-interference type optical current sensor 50, and according to the third embodiment, the explanation was given of the multi-stage optical voltage measuring apparatus 30 that has the sensor unit 3 of the optical voltage measuring apparatus 10 replaced with the two stage sensor units. The structure of the second embodiment and that of the third embodiment may be combined to accomplish a combination of the optical voltage measuring apparatus 10 including two-stage sensor units 3 with the inline-Sagnac-interference type optical current sensor 50.
(2) According to the third embodiment, the explanation was given of an example case in which the multi-stage optical voltage measuring apparatus 30 includes the two-stage sensor units 3, but the number of stages is optional as needed.
(3) According to the third embodiment, only either one of the first and second sensor units 3a, 3b may perform the temperature correction utilizing the temperature characteristics of the Faraday rotator 32 explained in the first embodiment.
(4) Several embodiments of the present disclosure were explained in this specification, but those embodiments are merely presented as examples, and are not intended to limit the scope and spirit of the present disclosure. The above-explained embodiments can be carried out in various other forms, and permit various omissions, replacements, and modifications without departing from the scope and spirit of the present disclosure. Such embodiments and modifications thereof are within the scope and spirit of the present disclosure, and also within an equivalent range to the subject matter as recited in appended claims.

## Claims

1. An optical voltage measuring apparatus comprising at least:
a light source;
a first optical element converting light from the light source into linear polarized light;
a phase modulator applying phase modulation to light converted into the linear polarized light;
a fiber disposed so as to propagate the light converted into the linear polarized light in both of a delayed-phase axis and an advanced-phase axis;
a second optical element turning polarized wave of emitted light from the fiber;
an electro-optic element applying a refraction index change by a Pockels effect to the turned light;
a reflector mirror reflecting light that has passed through the electro-optic element;
an optical branching device branching the light which has been reflected by the reflector mirror and which has passed through the electro-optic element; and
a detector detecting the branched light by the optical branching device,
wherein:
when a temperature coefficient of a sensitivity of the electro-optic element is positive, incident polarized light orientation of the second optical element to the electro-optic element is set so as to be coaxial with an axis of birefringence that appears by the Pockels effect at a lowest temperature in a service temperature range; and
when the temperature coefficient of the sensitivity of the electro-optic element is negative, the incident polarized light orientation of the second optical element to the electro-optic element is set so as to be coaxial with the axis of birefringence that appears by the Pockels effect at a highest temperature in the service temperature range.

2. The optical voltage measuring apparatus according to claim 1, further comprising an inline-Sagnac-interference type optical current sensor that comprises at least:
a light source;
a polarizer converting light from the light source into linear polarized light;
a phase modulator applying phase modulation to light converted into the linear polarized light;
a fiber disposed so as to propagate the light converted into the linear polarized light in both of a delayed-phase axis and an advanced-phase axis;
a 1/4 wavelength plate causing a phase difference by 1/4 wavelength to incident light;
a sensor fiber causing a Faraday phase difference;
a reflector mirror reflecting light that has passed through the sensor fiber;
an optical branching device branching the light which has been reflected by the reflector mirror and which has passed through the sensor fiber; and
a detector detecting the branched light by the optical branching device.

3. The optical voltage measuring apparatus according to claim 1 or 2, wherein a plurality of the electro-optic elements are connected in series.

4. An optical voltage measuring apparatus comprising at least:
a light source;
a first optical element converting light from the light source into linear polarized light;
a phase modulator applying phase modulation to light converted into the linear polarized light;
a fiber disposed so as to propagate the light converted into the linear polarized light in both of a delayed-phase axis and an advanced-phase axis;
a second optical element turning polarized wave of emitted light from the fiber;
an electro-optic element applying a refraction index change by a Pockels effect to the turned light;
a reflector mirror reflecting light that has passed through the electro-optic element;
an optical branching device branching the light which has been reflected by the reflector mirror and which has passed through the electro-optic element; and
a detector detecting the branched light by the optical branching device,
wherein the electro-optic element comprises an electro-optic element with an optical rotation characteristic that turns a polarized wave of incident light.
